(19) **Europäisches Patentamt / European Patent Office / Office européen des brevets**

(11) **EP 4 484 621 A1**

(12) **EUROPEAN PATENT APPLICATION**
published in accordance with Art. 153(4) EPC

(43) Date of publication:
01.01.2025 Bulletin 2025/01

(51) International Patent Classification (IPC):
$C30B\ 29/38^{(2006.01)}$     $C23C\ 16/34^{(2006.01)}$
$C30B\ 25/20^{(2006.01)}$     $H01L\ 21/205^{(2006.01)}$

(21) Application number: 23759940.2

(22) Date of filing: 20.02.2023

(52) Cooperative Patent Classification (CPC):
C23C 16/34; C30B 25/20; C30B 29/38;
H01L 21/2015

(86) International application number:
PCT/JP2023/006086

(87) International publication number:
WO 2023/162939 (31.08.2023 Gazette 2023/35)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 22.02.2022 JP 2022026202
22.02.2022 JP 2022026203

(71) Applicant: **Mitsubishi Chemical Corporation**
**Tokyo 100-8251 (JP)**

(72) Inventors:
• **ISO, Kenji**
**Tokyo 100-8251 (JP)**
• **ICHINOSE, Jun**
**Tokyo 100-8251 (JP)**

(74) Representative: **Hoffmann Eitle**
**Patent- und Rechtsanwälte PartmbB**
**Arabellastraße 30**
**81925 München (DE)**

(54) **GAN SUBSTRATE**

(57) The present invention provides an SI substrate having a high electrical resistivity under high temperatures or an SI substrate having excellent semi-insulation capability and excellent crystal quality. This GaN substrate is: a manganese-doped GaN substrate that has a carrier activation energy Ea of 0.7 eV or greater when the carrier density is shown by formula (I): carrier density (atoms/cm³) = AxEXP (-Ea/kT); or a GaN substrate that has a positive correlation of the carrier mobility versus temperature.

FIG. 7

**Description**

TECHNICAL FIELD

The present invention relates to a gallium nitride (GaN) substrate, and more particularly to a semi-insulating GaN substrate used for a radio-frequency device.

BACKGROUND ART

In recent years, a GaN-based high electron mobility transistor (HEMT) (hereinafter, may be referred to as "GaN-HEMT") has been actively developed for radio-frequency devices of several tens of GHz to several hundreds of GHz. The GaN-HEMT is formed by the crystal growth of GaN on a substrate. Silicon, silicon carbide (SiC), GaN, and the like have been studied as substrates used for a GaN-HEMT, and a GaN-HEMT using a GaN substrate is expected to have excellent performance compared with a GaN-HEMT using another substrate. The GaN-HEMT repeatedly turns a current on and off at the radio frequency, but ideally, it is required that no current flows when the device is in an OFF state. Therefore, a GaN substrate used for the GaN-HEMT is required to have a high resistance, and the GaN substrate is made semi-insulating to be a semi-insulating substrate (SI substrate).
A method for performing doping with a transition metal element has been known as a method for making a GaN substrate semi-insulating. The transition metal element acts as an acceptor, and therefore, the transition metal element compensates for a background donor unintentionally introduced into the GaN substrate, and has an effect of decreasing a carrier concentration of the GaN substrate. The transition metal element is referred to as a compensation impurity.
For example, in the invention described in Non-Patent Literature 1, a GaN substrate doped with iron (Fe) or manganese (Mn) as a compensation impurity is obtained.

CITATION LIST

NON-PATENT LITERATURE

Non-Patent Literature 1: M Iwinska et al., "Iron and manganese as dopants used in the crystallization of highly resistive HVPE-GaN on native seeds", Japanese Journal of Applied Physics, Vol. 58, SC1047, 2019

SUMMARY OF INVENTION

TECHNICAL PROBLEM

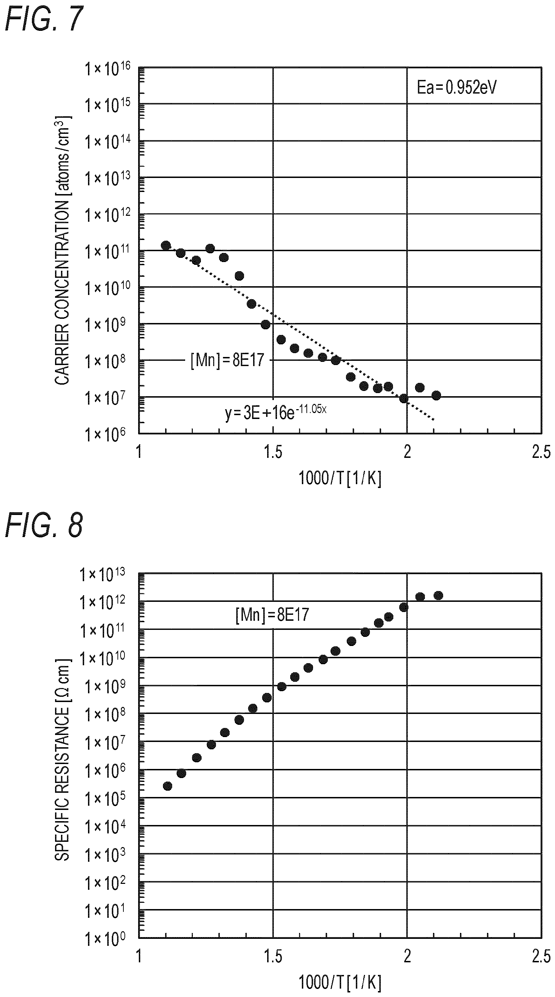

In the related art, the specific resistance of an SI substrate has been discussed as a value at a temperature approaching room temperature, and it is known that the resistivity decreases as the temperature increases. Non-Patent Literature 1 also shows that the higher the temperature of the GaN substrate doped with Mn is, the lower the resistivity is (Fig. 8. (a)).
In recent years, the field of use of radio-frequency devices has been expanding, and along with this expanding, opportunities to be used in severe regions such as high-temperature environments have also been increased. Accordingly, implementation of a radio-frequency device capable of withstanding a high-temperature environment is one of important objects for improving reliability of operations in a wide range of use environments and processing/controllability of a large amount of information.
Therefore, a first object of the present invention is to provide an SI substrate having a large resistivity even in a high-temperature environment.
As described above, the SI substrate is required to have excellent semi-insulating properties, and it is also important to simultaneously improve the crystal quality of a GaN single crystal forming the SI substrate. In the case where the crystal quality of the SI substrate is poor, there is a concern that the epitaxial growth of the GaN buffer layer on the SI substrate may be adversely affected or the performance of the device may deteriorate due to defects or the like of the SI substrate.
Therefore, a second object of the present invention is to provide an SI substrate excellent in semi-insulating properties and crystal quality.

SOLUTION TO PROBLEM

The present inventors have conducted extensive studies on the above objects.
The present inventors have found that the above first object can be achieved by forming a GaN substrate by a crystal doped with Mn and having large carrier activation energy (Ea), and have completed the present invention.

The present inventors have conducted extensive studies on the above second object, and have found that a GaN substrate excellent in semi-insulating properties can be obtained by using Mn as a compensation impurity as compared with the case where other compensation impurities are used. The present inventors have found that a Mn-doped GaN substrate having excellent crystal quality can be stably obtained by focusing on the carrier mobility and the carrier type of the Mn-doped GaN substrate, and have completed the present invention.

That is, the gist of the present invention is as follows.

<1> A GaN substrate, which is a GaN substrate doped with manganese, in which an activation energy of a carrier is 0.7 eV or more when a carrier concentration is represented by the following formula (I):

$$\text{carrier concentration (atoms/cm}^3) = A \times \text{EXP}(-Ea/kT) \qquad (I),$$

in which A represents a proportional constant, EXP represents an exponential function, Ea represents a carrier activation energy (eV), k represents a Boltzmann constant ($8.617 \times 10^{-5}$ eV/K), and T represents a temperature (K) in Kelvin units.

<2> The GaN substrate according to <1>, in which the activation energy Ea of the carrier is 0.7 eV to 1.2 eV

<3> The GaN substrate according to <1>, in which the activation energy Ea of the carrier is determined by a least squares method, and a determination coefficient $R^2$ of an approximation curve when performing exponential approximation by the least squares method is 0.9 or more.

<4> The GaN substrate according to <1>, in which the activation energy Ea of the carrier is obtained by fitting a carrier concentration measured by changing a temperature in a temperature range of 450 K to 950 K at intervals of 50 K to the formula (I).

<5> A GaN substrate, which is a GaN substrate doped with manganese, in which a carrier concentration at 900 K is less than $1 \times 10^{13}$ atoms/cm$^3$.

<6> A GaN substrate, which has a specific resistance at 900 K of $5 \times 10^4$ Ωcm or more.

<7> The GaN substrate according to <6>, which is a GaN substrate doped with manganese.

<8> The GaN substrate according to any one of <1> to <7>, in which a type of the carrier is p-type.

<9> The GaN substrate according to any one of <1> to <8>, in which a dislocation density is $1 \times 10^6$ cm$^{-2}$ or less.

<10> A GaN substrate, which is a GaN substrate doped with manganese, in which carrier mobility has a positive correlation with temperature.

<11> A GaN substrate, which is a GaN substrate doped with manganese, in which a ratio $\mu_H/\mu_L$ of carrier mobility $\mu_H$ at 800 K to carrier mobility $\mu_L$ at 650 K is 1 or more.

<12> A GaN substrate, which is a GaN substrate doped with manganese, in which a type of a carrier is p-type.

<13> A GaN substrate, which is a semi-insulating GaN substrate, in which carrier mobility at 900 K is 50 cm$^2$/Vs or more.

<14> The GaN substrate according to <13>, which is a GaN substrate doped with manganese.

<15> The GaN substrate according to any one of <10> to <14>, in which a dislocation density is $1 \times 10^6$ cm$^{-2}$ or less.

ADVANTAGEOUS EFFECTS OF INVENTION

The GaN substrate according to the present invention is superior in crystal quality to a Mn-doped GaN substrate according to the related art, and therefore, an activation energy of carriers is large. Therefore, the GaN substrate according to the present invention can maintain a high resistance even in a high-temperature environment.

The GaN substrate according to the present invention has a higher specific resistance due to doping with Mn, and at the same time, the carrier mobility and carrier type exhibit specific behavior, which means that the crystal quality of GaN single crystals forming the GaN substrate is very excellent.

Therefore, the GaN substrate according to the present invention is very suitable as a substrate used for a nitride semiconductor device having a horizontal device structure such as a GaN-HEMT.

BRIEF DESCRIPTION OF DRAWINGS

[FIG. 1] FIG. 1 is a plan view showing a (0001) surface of a GaN substrate according to an embodiment, which is divided into cells each having a size of 5 mm × 5 mm by square lattices.
[FIG. 2] FIG. 2 is a cross-sectional view showing a single-crystal GaN substrate according to the embodiment.
[FIG. 3] FIG. 3 is a cross-sectional view showing the single-crystal GaN substrate according to the embodiment.

[FIG. 4] FIG. 4 is a cross-sectional view of a process, which illustrates a method for producing a GaN substrate according to the present embodiment.

[FIG. 5] FIG. 5 is a cross-sectional view of a process, which illustrates the method for producing the GaN substrate according to the present embodiment.

[FIG. 6] FIG. 6 is a schematic diagram showing a basic configuration of an HVPE device.

[FIG. 7] FIG. 7 is a graph showing measurement results of a carrier concentration of a GaN substrate according to Example 1-1.

[FIG. 8] FIG. 8 is a graph showing measurement results of specific resistance of the GaN substrate according to Example 1-1.

[FIG. 9] FIG. 9 is a graph showing measurement results of carrier mobility of GaN substrates of Examples 2-1 and 2-2.

DESCRIPTION OF EMBODIMENTS

Hereinafter, embodiments of the present invention are specifically described, but the present invention is not limited to the following embodiments, and the present invention can be implemented with various modifications within the scope of a gist thereof.

In the present disclosure, a crystal axis parallel to a [0001] axis is called a c-axis, a crystal axis parallel to a <10-10> axis is called an m-axis, and a crystal axis parallel to a <11-20> axis is called an a-axis. A crystal plane perpendicular to the c-axis is called a c-plane, a crystal plane perpendicular to the m-axis is called an m-plane, and a crystal plane perpendicular to the a-axis is called an a-plane.

The Miller index (h k i l) of a hexagonal crystal has a relationship of h + k = -i, and therefore, it may also be represented by three digits of (h k l). For example, (0004) is represented in three digits as (004).

In the present description, when referring to a crystal axis, a crystal plane, a crystal orientation, and the like, they mean a crystal axis, a crystal plane, a crystal orientation, and the like in a GaN substrate or a GaN layer, unless otherwise specified.

In the present description, the Mn concentration and the C concentration of a specific position are values determined by respective detection amounts using secondary ion mass spectrometry (SIMS).

In the present description, the term "(0001) surface" means a "surface having an inclination of 10 degrees or less (including 0 degree) from the (0001) crystal plane" unless otherwise specified. The term "(000-1) surface" means a "surface having an inclination of 10 degrees or less (including 0 degree) from a (000-1) crystal plane" unless otherwise specified.

In the present description, the expression "to" is used as an expression including numerical values or physical property values before and after the expression. That is, "A to B" means A or more and B or less.

Moreover, in the present description, "mass" is synonymous with "weight".

<First Aspect>

(GaN Substrate)

A GaN substrate according to a first embodiment in a first aspect (Embodiment 1-1) is a GaN substrate doped with manganese (Mn), and when a carrier concentration is represented by the following formula (I), an activation energy Ea of carriers is 0.7 or more.

$$\text{carrier concentration (atoms/cm}^3) = A \times \text{EXP}(-Ea/kT) \qquad (I),$$

in which A represents a proportional constant, EXP represents an exponential function, Ea represents a carrier activation energy (eV), k represents a Boltzmann constant ($8.617 \times 10^{-5}$ eV/K), and T represents a temperature (K) in Kelvin units.

When the resistance of the GaN crystal is increased and the activation energy Ea of the carriers in the GaN substrate is 0.7 eV or more by doping with Mn, the carrier concentration at a high temperature tends to decrease. Accordingly, in the GaN substrate according to the first embodiment, an increase in the carrier concentration at a high temperature is small, and the specific resistance under a high-temperature environment can be maintained high.

The GaN substrate according to the first embodiment in the first aspect has a Mn-doped layer obtained by doping the GaN substrate with Mn. A thickness of the Mn-doped layer in a c-axis direction is not required to coincide with a thickness of the GaN substrate in the c-axis direction.

For example, a thickness of the entire GaN substrate is 400 μm, whereas the thickness of the Mn-doped layer is sufficient if it is included in top 100 μm of the GaN substrate. Of course, the thickness of the Mn-doped layer is not limited to the above, and the case where the Mn-doped layer has a thickness larger or smaller than the above thickness is not excluded at all. In addition, a GaN substrate in which the entire GaN substrate in the thickness direction is formed by the Mn-doped layer may be used.

A Mn concentration of the GaN substrate is preferably $1.0 \times 10^{16}$ atoms/cm$^3$ or more and $1.0 \times 10^{20}$ atoms/cm$^3$ or less. Mn, which is a compensation impurity, contributes to an increase in resistance. When the Mn concentration is $1.0 \times 10^{16}$ atoms/cm$^3$ or more, the resistance of the GaN crystal can be increased, and when the Mn concentration is $1.0 \times 10^{20}$ atoms/cm$^3$ or less, good crystal quality can be maintained.

From the viewpoint of the impurity levels, the doping with Mn is superior to the doping with other compensation impurities such as Fe (iron). This is because a level of Mn is deeper than that of Fe, and greater energy is required for trapped electrons to return to a conduction band.

As an upper limit of the Mn concentration of the GaN substrate, the Mn concentration is preferably $6.0 \times 10^{19}$ atoms/cm$^3$ or less, $5.0 \times 10^{19}$ atoms/cm$^3$ or less, $3.0 \times 10^{19}$ atoms/cm$^3$ or less, $1.0 \times 10^{19}$ atoms/cm$^3$ or less, or $5.0 \times 10^{18}$ atoms/cm$^3$ or less. As a lower limit thereof, the Mn concentration of the GaN substrate is preferably $1.0 \times 10^{16}$ atoms/cm$^3$ or more, $3.0 \times 10^{16}$ atoms/cm$^3$ or more, $5.0 \times 10^{16}$ atoms/cm$^3$ or more, $1.0 \times 10^{17}$ atoms/cm$^3$ or more, $3.0 \times 10^{17}$ atoms/cm$^3$ or more, or $5.0 \times 10^{17}$ atoms/cm$^3$ or more, in a stepwise manner.

As impurities acting as donors for GaN, O (oxygen), Si (silicon), S (sulfur), Ge (germanium), Sn (tin), and the like are known. The donor impurities inhibit the effect of increasing the resistance of the compensation impurities, and therefore, a total donor impurity concentration of the GaN substrate is preferably less than $5.0 \times 10^{16}$ atoms/cm$^3$. When the total donor impurity concentration of the GaN substrate is preferably less than $5.0 \times 10^{16}$ atoms/cm$^3$, the resistivity of the GaN substrate is hardly affected by the variation in donor impurity concentration, and a high resistivity can be achieved even at a relatively low Mn concentration. The total donor impurity concentration is the sum of concentrations of donor impurities contained in the GaN substrate.

The total donor impurity concentration is preferably less than $4.0 \times 10^{16}$ atoms/cm$^3$, and more preferably less than $2.0 \times 10^{16}$ atoms/cm$^3$. The amount of donor impurities is preferably as small as possible, and therefore, there is no particular lower limit.

As will be described below, the Mn-doped GaN crystal for obtaining the GaN substrate can be grown by hydride vapor phase epitaxy (HVPE), and therefore, O (oxygen) and Si (silicon) may be contained in the GaN substrate at a concentration of $10^{15}$ atoms/cm$^3$ or more although they are not intentionally added. On the other hand, donor impurities other than O and Si are contained in the GaN substrate at a non-negligible concentration only when the GaN substrate is intentionally doped with such donor impurities. Note that "intentionally doping" means, for example, a case where the element is added in the form of a simple substance or a compound as a raw material in order to dope the GaN crystal with the target element.

Therefore, unless the GaN substrate is intentionally doped with the donor impurities other than O and Si, the total donor impurity concentration of the GaN substrate may be considered to be equal to the sum of the O concentration and the Si concentration. Whether the GaN substrate is doped with the donor impurities other than O and Si can be checked by an elemental analysis or the like.

The GaN substrate may contain C (carbon), which is one of the compensation impurities, at a concentration equal to or higher than a detection lower limit (about $5 \times 10^{15}$ atoms/cm$^3$) by secondary ion mass spectrometry (SIMS), and at a concentration that is preferably less than $1 \times 10^{17}$ atoms/cm$^3$, and more preferably less than $5 \times 10^{16}$ atoms/cm$^3$.

The GaN substrate may contain compensation impurities other than Mn and C, such as Fe (iron), Co (cobalt), and Ni (nickel), as long as no problem occurs in practical use.

The GaN substrate may contain H (hydrogen) in addition to the impurities mentioned above, and the concentration thereof may be, for example, in the range of $10^{16}$ to $10^{17}$ atoms/cm$^3$.

A threading dislocation density (hereinafter, may be referred to as "dislocation density") of the GaN substrate is generally less than $1 \times 10^7$ cm$^{-2}$, and from the viewpoint of crystallinity, the threading dislocation density is preferably $5 \times 10^6$ cm$^{-2}$ or less, more preferably $1 \times 10^6$ cm$^{-2}$ or less, still more preferably $5 \times 10^5$ cm$^{-2}$ or less, and particularly preferably $1 \times 10^5$ cm$^{-2}$ or less.

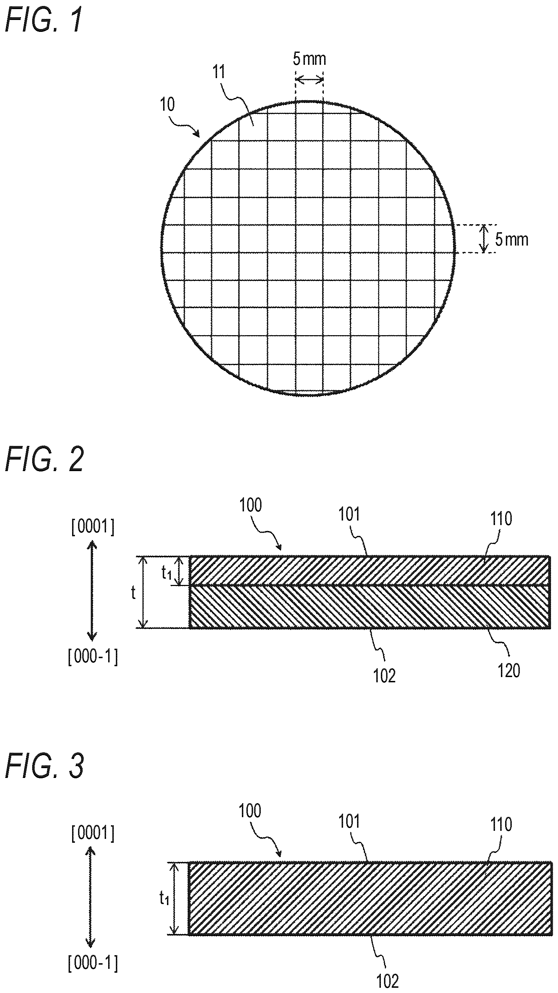

When the (0001) surface of the GaN substrate is divided into cells each having a size of 5 mm $\times$ 5 mm by square lattices as shown in FIG. 1, it is particularly preferable that at least one square region of 100 $\mu$m $\times$ 100 $\mu$m without threading dislocations is present in each cell of 5 mm $\times$ 5 mm.

The dislocation density can be adjusted by a GaN crystal growth method such as a vapor phase method or a liquid phase method, the crystal characteristics, crystal growth conditions, selection of a surface for growth, the content of impurities, and the like of a seed substrate used for growing a GaN crystal.

The dislocation density has the same meaning as a dark spot density measured by cathodoluminescence (CL).

There are three types of threading dislocations: an edge threading dislocation, a screw threading dislocation, and a mixed threading dislocation. In this description, no distinction is made between the three types of threading dislocations and they are collectively referred to as the threading dislocation.

The presence or absence and density of threading dislocations in the GaN substrate can be examined by performing etching for 1 hour with sulfuric acid having a mass concentration of 89% and heated to 270°C. The etch pits formed on the (0001) surface by such etching correspond to threading dislocations, and a density of the etch pits is equivalent to the threading dislocation density. This is confirmed by examining a correspondence relationship between an etch pit formed when a conductive GaN crystal grown by HVPE is etched under the same conditions and a dark spot appearing in a cathodoluminescence (CL) image.

The GaN substrate according to the first embodiment in the first aspect may be formed of the above Mn-doped GaN crystal, or may have a structure obtained by laminating a seed crystal layer and a Mn-doped layer. In the case where the Mn-doped layer and the seed crystal layer are provided, the GaN substrate according to the first embodiment includes a first region 110 and a second region 120 as shown in FIG. 2.

FIG. 2 shows a cross section obtained by cutting a Mn-doped GaN substrate 100 along a plane perpendicular to a (0001) surface 101.

In the Mn-doped GaN substrate 100, the first region 110 including the (0001) surface 101 is preferably made of a Mn-doped GaN crystal.

The Mn-doped GaN substrate 100 may have the second region 120 on a (000-1) surface 102 side, and the second region 120 may be made of a GaN crystal having a room temperature resistivity of less than $1 \times 10^5$ Ωcm (that is, a GaN crystal that is not semi-insulating).

A total concentration of compensation impurities in the second region 120 is generally lower than that of the first region 110. The second region 120 may have, in a vicinity of a boundary with the first region 110, a region in which the total concentration of the compensation impurities increases stepwise or continuously as approaching the first region 110.

The Mn-doped GaN substrate 100 having the first region 110 and the second region 120 can be produced by forming the second region 120 on the first region 110 by epitaxial growth or forming the first region 110 on the second region 120 by epitaxial growth.

The Mn-doped GaN substrate according to the first embodiment in the first aspect has the Ga polar (0001) surface 101 and the N polar (000-1) surface 102.

In the case where the Mn-doped GaN substrate includes the seed crystal layer and the Mn-doped layer, a surface of the first region 110 which is the Mn-doped layer is the (0001) surface 101, and a surface of the second region 120 which is the seed crystal layer is the (000-1) surface 102, as shown in FIG. 2.

In the case where the Mn-doped GaN substrate is formed of the Mn-doped GaN crystal, one surface of the Mn-doped layer is the (0001) surface 101 and the other surface is the (000-1) surface 102, as shown in FIG. 3.

A diameter of the Mn-doped GaN substrate is generally 20 mm or more, and may be any size such as 25 mm to 27 mm (about 1 inch), 50 mm to 55 mm (about 2 inches), 100 mm to 105 mm (about 4 inches), or 150 mm to 155 mm (about 6 inches).

A thickness t of the Mn-doped GaN substrate is set, according to the diameter, to a value at which handling of the Mn-doped GaN substrate is not difficult. For example, when the diameter of the Mn-doped GaN substrate is about 2 inches, the thickness of the Mn-doped GaN substrate is preferably 250 μm to 500 μm, and more preferably 300 μm to 450 μm.

In the case where the Mn-doped GaN substrate has a configuration in which the seed crystal layer and the Mn-doped layer are laminated as shown in FIG. 2, a thickness $t_1$ of the first region 110 which is the Mn-doped layer is preferably 80 μm to 200 μm, and more preferably 100 μm to 150 μm.

In two large-area surfaces of the Mn-doped GaN substrate, the (0001) surface 101 is used as a front surface for the epitaxial growth of a nitride semiconductor layer. The (0001) surface 101 is mirror-finished, and a root mean square (RMS) roughness thereof measured with an AFM is generally less than 2 nm, preferably less than 1 nm, and more preferably less than 0.5 nm in a measurement range of 2 μm × 2 μm.

The (000-1) surface 102 is a back surface, and therefore, the plane may be mirror-finished or rough-finished.

An edge of the Mn-doped GaN substrate may be chamfered.

The Mn-doped GaN substrate may be provided with various markings as necessary, such as orientation flats and notches for indicating an orientation of a crystal, and an index flat for facilitating the identification of a front surface and a back surface.

A shape of the Mn-doped GaN substrate is not particularly limited, and the shapes of the (0001) surface and the (000-1) surface may be a disk shape, a square shape, a rectangular shape, a hexagonal shape, an octagonal shape, an elliptical shape, or the like, or may be an irregular shape.

Regarding the Mn-doped GaN substrate according to the first embodiment in the first aspect, when the carrier concentration thereof is represented by the following formula (I), the activation energy Ea of the carriers is in a range of 0.7 eV or more, and preferably in a range of 0.7 eV to 1.2 eV

$$\text{carrier concentration (atoms/cm}^3) = A \times \text{EXP(-Ea/kT)} \qquad \text{(I)},$$

in which A represents a proportional constant, EXP represents an exponential function, Ea represents a carrier activation energy (eV), k represents a Boltzmann constant ($8.617 \times 10^{-5}$ eV/K), and T represents a temperature (K) in Kelvin units.

When the activation energy Ea of the carriers is in the above range, a decrease in specific resistance under a high temperature is prevented, and a GaN substrate whose high resistance is maintained under a high-temperature environment is obtained. From the same viewpoint, the activation energy Ea of the carriers is preferably 0.8 eV or more, and more preferably 0.9 eV or more, and is preferably 1.1 eV or less, and more preferably 1.0 eV or less.

The above activation energy Ea of the carriers is determined by the least squares method from a scatter diagram of the carrier concentration and 1/T. A temperature range for determining the activation energy Ea of the carriers is not particularly limited, and from the viewpoint of reliability of data, the temperature range is preferably set to a range of 450°C or higher to determine Ea. The manganese-doped substrate has a very high specific resistance, and therefore, it is difficult to perform an accurate measurement at a temperature approaching room temperature. However, this is because the specific resistance decreases to a measurable range when the temperature is 450°C or higher.

In addition, according to the least squares method, it is desirable that a determination coefficient $R^2$ of an approximation curve when performing exponential approximation is 0.9 or more. When $R^2$ is less than 0.9, the value of the activation energy Ea is unreliable.

Specifically, the activation energy Ea of the carriers can be obtained by fitting a carrier concentration measured by changing the temperature at intervals of 50K in a temperature range of 450 K to 950 K to the formula (I) by the least squares method.

The present inventors have repeated studies and focused on a relationship between the activation energy of the carriers and the specific resistance under a high temperature, and have conceived the possibility of obtaining, by controlling the activation energy of the carriers in a specific range, a GaN substrate whose high resistance is maintained even under a high-temperature environment. Here, it is considered that the value of the activation energy of the carriers in the GaN crystal is affected by the quality of the GaN crystal. For example, in a GaN crystal with poor crystal quality, a large number of carrier trap levels are present due to defects or the like in the crystal, and a large carrier activation energy cannot be achieved. In particular, Mn-doped GaN crystals according to the related art were not satisfactory in terms of crystal quality, and therefore, it is considered that a Mn-doped GaN substrate having large activation energy of carriers could not be obtained. The present inventors have succeeded in obtaining a GaN crystal excellent in crystal quality by reviewing a method for producing a Mn-doped GaN crystal or the like as described below. Accordingly, a Mn-doped GaN substrate having a large activation energy of carriers was achieved.

In the Mn-doped GaN substrate according to the first embodiment in the first aspect, the carrier concentration at 900 K is preferably less than $1 \times 10^{13}$ atoms/cm$^3$. When the carrier concentration at 900 K is in the above range, a sufficiently large specific resistance can be obtained even in a high-temperature environment because the specific resistance is inversely proportional to the carrier concentration.

The carrier concentration at 900 K is more preferably $5 \times 10^{12}$ atoms/cm$^3$ or less, still more preferably $2 \times 10^{12}$ atoms/cm$^3$ or less, and particularly preferably $1 \times 10^{12}$ atoms/cm$^3$ or less. From the viewpoint of specific resistance, the carrier concentration at 900 K is preferably as low as possible, and therefore, the lower limit is not particularly limited.

The carrier concentration is also considered to be affected by the crystal quality of the GaN crystal. According to the studies of the present inventors, the carrier concentration at a high temperature such as 900 K tends to more strongly reflect the influence of the crystal quality of the GaN crystal than the carrier concentration at a temperature approaching room temperature. It is considered that a GaN substrate having a low carrier concentration at 900 K can be obtained by improving the crystal quality of the Mn-doped GaN crystal.

The carrier concentration, specific resistance, and carrier type can be determined by using Hall effect measurement.

The Mn-doped GaN substrate according to the first embodiment in the first aspect preferably has a specific resistance at 900 K of $5 \times 10^4$ Ωcm or more. When the specific resistance at 900 K is in the above range, the Mn-doped GaN substrate can be operated in a wide range of use environments without lowering the resistivity even when used in a high-temperature environment.

The specific resistance at 900 K is more preferably $1 \times 10^5$ Ωcm or more, still more preferably $2 \times 10^5$ Ωcm or more, and particularly preferably $5 \times 10^5$ Ωcm or more. In addition, the upper limit is not particularly limited because a higher specific resistance is more preferred.

In the Mn-doped GaN substrate according to the first embodiment in the first aspect, the carrier type is preferably p-type. In the case where the crystal quality of the GaN substrate is not good, electrons caused by impurities such as Si and O which are not intended are not sufficiently compensated even if doping with Mn is performed, and the GaN substrate tends to be n-type. Therefore, the p-type carrier means that the crystallinity of a GaN single crystal forming the GaN substrate is good.

A GaN substrate according to the second embodiment in the first aspect (Embodiment 1-2) is a GaN substrate doped with manganese, and a carrier concentration at 900 K is less than $1 \times 10^{13}$ atoms/cm$^3$.

Similarly to the first embodiment, the resistance of the GaN crystal is increased by doping with Mn. When the carrier concentration at 900 K of the GaN substrate is less than $1 \times 10^{13}$ atoms/cm$^3$, the Mn-doped GaN substrate according to the second embodiment has a small increase in the carrier concentration at a high temperature and can maintain a high specific resistance under a high-temperature environment.

Similarly to the first embodiment, the GaN substrate according to the second embodiment in the first aspect may be a substrate formed only of the Mn-doped layer, or may be a substrate having a structure obtained by laminating the seed crystal layer and the Mn-doped layer.

The properties and characteristics of the Mn-doped GaN substrate according to the second embodiment in the first aspect are the same as the properties and characteristics of the Mn-doped GaN substrate according to the first embodiment.

In the Mn-doped GaN substrate according to the second embodiment in the first aspect, the carrier concentration at 900 K is less than $1 \times 10^{13}$ atoms/cm$^3$. When the carrier concentration at 900 K of the Mn-doped GaN substrate is less than $1 \times 10^{13}$ atoms/cm$^3$, a sufficiently large specific resistance can be obtained even in a high-temperature environment because the specific resistance is inversely proportional to the carrier concentration.

The carrier concentration at 900 K is preferably $5 \times 10^{12}$ atoms/cm$^3$ or less, more preferably $2 \times 10^{12}$ atoms/cm$^3$ or less, and still more preferably $1 \times 10^{12}$ atoms/cm$^3$ or less. From the viewpoint of specific resistance, the carrier concentration at 900 K is preferably as low as possible, and therefore, the lower limit is not particularly limited.

The carrier concentration is also considered to be affected by the crystal quality of the GaN crystal. According to the studies of the present inventors, the carrier concentration at a high temperature such as 900 K tends to more strongly reflect the influence of the crystal quality of the GaN crystal than the carrier concentration at a temperature approaching room temperature. It is considered that a GaN substrate having a low carrier concentration at 900 K can be obtained by improving the crystal quality of the Mn-doped GaN crystal.

The layer structure, size, shape, carrier activation energy, specific resistance, and the like of the Mn-doped GaN substrate according to the second embodiment in the first aspect are the same as the layer structure, size, shape, carrier activation energy, specific resistance, and the like in the first embodiment, respectively.

A GaN substrate according to the third embodiment in the first aspect (Embodiment 1-3) has a specific resistance at 900 K of $5 \times 10^4$ Ωcm or more. When the specific resistance at 900 K of the GaN substrate is $5 \times 10^4$ Ωcm or more, a high resistance can be maintained under a high-temperature environment, and therefore, the GaN substrate is suitable for application to a radio-frequency device.

The specific resistance at 900 K of the GaN substrate is preferably $1 \times 10^5$ Ωcm or more, more preferably $2 \times 10^5$ Ωcm or more, and still more preferably $5 \times 10^5$ Ωcm or more from the viewpoint of increasing the resistance. The upper limit is not particularly limited because a higher specific resistance is more preferred.

The GaN substrate according to the third embodiment in the first aspect may be a substrate formed of only a layer made of a GaN crystal, or may be a substrate having a structure obtained by laminating a seed crystal layer and the layer made of a GaN crystal.

In order to set the specific resistance at 900 K of the GaN substrate to $5 \times 10^4$ Ωcm or more, for example, a method for doping the GaN crystal with Mn is exemplified.

Among them, the GaN substrate according to the third embodiment in the first aspect preferably has a Mn-doped layer obtained by doping with Mn. The presence of the Mn-doped layer can increase the resistance of the GaN crystal to obtain a desired specific resistance.

The properties and characteristics of the Mn-doped GaN crystal in the GaN substrate according to the third embodiment in the first aspect are the same as the properties and characteristics of the Mn-doped GaN crystal in the first embodiment. In addition, the layer structure, size, shape, carrier activation energy, specific resistance, and the like of the GaN substrate according to the third embodiment are the same as the layer structure, size, shape, carrier activation energy, specific resistance, and the like in the first embodiment, respectively.

<Second Aspect>

(GaN Substrate)

A GaN substrate according to the first embodiment in the second aspect (Embodiment 2-1) is a GaN substrate doped with manganese (Mn), and the carrier mobility has a positive correlation with temperature.

The resistance of the GaN crystal is increased by doping with Mn. At the same time, the fact that the carrier mobility of the GaN substrate has a positive correlation with the temperature indicates that there are very few microscopic defects inside the GaN single crystal forming the GaN substrate and the crystal quality is excellent. Accordingly, the GaN substrate according to the first embodiment in the second aspect can achieve both high specific resistance and excellent crystal quality.

The GaN substrate according to the first embodiment in the second aspect has a Mn-doped layer obtained by doping the GaN substrate with Mn. A thickness of the Mn-doped layer in a c-axis direction is not required to coincide with a thickness of the GaN substrate in the c-axis direction. For example, a thickness of the entire GaN substrate is 400 μm, whereas the thickness of the Mn-doped layer is sufficient if it is included in top 100 μm of the GaN substrate. Of course, the thickness of the Mn-doped layer is not limited to the above, and the case where the Mn-doped layer has a thickness larger or smaller than the above thickness is not excluded at all. In addition, a GaN substrate in which the entire GaN substrate in the thickness direction is formed by the Mn-doped layer may be used.

A Mn concentration of the GaN substrate is preferably $1.0 \times 10^{16}$ atoms/cm$^3$ or more and $1.0 \times 10^{20}$ atoms/cm$^3$ or less. Mn, which is a compensation impurity, contributes to an increase in resistance. When the Mn concentration is $1.0 \times 10^{16}$ atoms/cm$^3$ or more, the resistance of the GaN crystal can be increased, and when the Mn concentration is $1.0 \times 10^{20}$ atoms/cm$^3$ or less, good crystal quality can be maintained.

From the viewpoint of the impurity levels, the doping with Mn is superior to the doping with other compensation impurities such as Fe (iron). This is because a level of Mn is deeper than that of Fe, and greater energy is required for trapped electrons to return to a conduction band.

As an upper limit of the Mn concentration of the GaN substrate, the Mn concentration is preferably $6.0 \times 10^{19}$ atoms/cm$^3$ or less, $5.0 \times 10^{19}$ atoms/cm$^3$ or less, $3.0 \times 10^{19}$ atoms/cm$^3$ or less, $1.0 \times 10^{19}$ atoms/cm$^3$ or less, or $5.0 \times 10^{18}$ atoms/cm$^3$ or less. As a lower limit thereof, the Mn concentration of the GaN substrate is preferably $1.0 \times 10^{16}$ atoms/cm$^3$ or more, $3.0 \times 10^{16}$ atoms/cm$^3$ or more, $5.0 \times 10^{16}$ atoms/cm$^3$ or more, $1.0 \times 10^{17}$ atoms/cm$^3$ or more, $3.0 \times 10^{17}$ atoms/cm$^3$ or more, or $5.0 \times 10^{17}$ atoms/cm$^3$ or more, in a stepwise manner.

As impurities acting as donors for GaN, O (oxygen), Si (silicon), S (sulfur), Ge (germanium), Sn (tin), and the like are known. The donor impurities inhibit the effect of increasing the resistance of the compensation impurities, and therefore, a total donor impurity concentration of the GaN substrate is preferably less than $5.0 \times 10^{16}$ atoms/cm$^3$. When the total donor impurity concentration of the GaN substrate is preferably less than $5.0 \times 10^{16}$ atoms/cm$^3$, the resistivity of the GaN substrate is hardly affected by the variation in donor impurity concentration, and a high resistivity can be achieved even at a relatively low Mn concentration. The total donor impurity concentration is the sum of concentrations of donor impurities contained in the GaN substrate.

The total donor impurity concentration is preferably less than $4.0 \times 10^{16}$ atoms/cm$^3$, and more preferably less than $2.0 \times 10^{16}$ atoms/cm$^3$. The amount of donor impurities is preferably as small as possible, and therefore, there is no particular lower limit.

As will be described below, the Mn-doped GaN crystal for obtaining the GaN substrate can be grown by hydride vapor phase epitaxy (HVPE), and therefore, O (oxygen) and Si (silicon) may be contained in the GaN substrate at a concentration of $10^{15}$ atoms/cm$^3$ or more although they are not intentionally added. On the other hand, donor impurities other than O and Si are contained in the GaN substrate at a non-negligible concentration only when the GaN substrate is intentionally doped with such donor impurities. Note that "intentionally doping" means, for example, a case where the element is added in the form of a simple substance or a compound as a raw material in order to dope the GaN crystal with the target element.

Therefore, unless the GaN substrate is intentionally doped with the donor impurities other than O and Si, the total donor impurity concentration of the GaN substrate may be considered to be equal to the sum of the O concentration and the Si concentration. Whether the GaN substrate is doped with the donor impurities other than O and Si can be checked by an elemental analysis or the like.

The GaN substrate may contain C (carbon), which is one of the compensation impurities, at a concentration equal to or higher than a detection lower limit (about $5 \times 10^{15}$ atoms/cm$^3$) by secondary ion mass spectrometry (SIMS), and at a concentration that is preferably less than $1 \times 10^{17}$ atoms/cm$^3$, and more preferably less than $5 \times 10^{16}$ atoms/cm$^3$.

The GaN substrate may contain compensation impurities other than Mn and C, such as Fe (iron), Co (cobalt), and Ni (nickel), as long as no problem occurs in practical use.

The GaN substrate may contain H (hydrogen) in addition to the impurities mentioned above, and the concentration thereof may be, for example, in the range of $10^{16}$ to $10^{17}$ atoms/cm$^3$.

A threading dislocation density (hereinafter, may be referred to as "dislocation density") of the GaN substrate is generally less than $1 \times 10^7$ cm$^{-2}$, and from the viewpoint of crystallinity, the threading dislocation density is preferably $5 \times 10^6$ cm$^{-2}$ or less, more preferably $1 \times 10^6$ cm$^{-2}$ or less, still more preferably $5 \times 10^5$ cm$^{-2}$ or less, and particularly preferably $1 \times 10^5$ cm$^{-2}$ or less.

When the (0001) surface of the GaN substrate is divided into cells each having a size of 5 mm $\times$ 5 mm by square lattices as shown in FIG. 1, it is particularly preferable that at least one square region of 100 $\mu$m $\times$ 100 $\mu$m without threading dislocations is present in each cell of 5 mm $\times$ 5 mm.

The dislocation density can be adjusted by a GaN crystal growth method such as a vapor phase method or a liquid phase method, the crystal characteristics, crystal growth conditions, selection of a surface for growth, the content of impurities, and the like of a seed substrate used for growing a GaN crystal.

The dislocation density has the same meaning as a dark spot density measured by cathodoluminescence (CL).

There are three types of threading dislocations: an edge threading dislocation, a screw threading dislocation, and a mixed threading dislocation. In this description, no distinction is made between the three types of threading dislocations and they are collectively referred to as the threading dislocation.

The presence or absence and density of threading dislocations in the GaN substrate can be examined by performing etching for 1 hour with sulfuric acid having a mass concentration of 89% and heated to 270°C. The etch pits formed on the (0001) surface by such etching correspond to threading dislocations, and a density of the etch pits is equivalent to the threading dislocation density. This is confirmed by examining a correspondence relationship between an etch pit formed when a conductive GaN crystal grown by HVPE is etched under the same conditions and a dark spot appearing in a cathodoluminescence (CL) image.

The GaN substrate according to the first embodiment in the second aspect may be formed of the above Mn-doped GaN crystal, or may have a structure obtained by laminating a seed crystal layer and a Mn-doped layer. In the case where the Mn-doped layer and the seed crystal layer are provided, the GaN substrate according to the first embodiment in the second aspect includes the first region 110 and the second region 120 as shown in FIG. 2.

FIG. 2 shows a cross section obtained by cutting a Mn-doped GaN substrate 100 along a plane perpendicular to a (0001) surface 101.

In the Mn-doped GaN substrate 100, the first region 110 including the (0001) surface 101 is preferably made of a Mn-doped GaN crystal.

The Mn-doped GaN substrate 100 may have the second region 120 on a (000-1) surface 102 side, and the second region 120 may be made of a GaN crystal having a room temperature resistivity of less than $1 \times 10^5$ Qcm (that is, a GaN crystal that is not semi-insulating).

A total concentration of compensation impurities in the second region 120 is generally lower than that of the first region 110. The second region 120 may have, in a vicinity of a boundary with the first region 110, a region in which the total concentration of the compensation impurities increases stepwise or continuously as approaching the first region 110.

The Mn-doped GaN substrate 100 having the first region 110 and the second region 120 can be produced by forming the second region 120 on the first region 110 by epitaxial growth or forming the first region 110 on the second region 120 by epitaxial growth.

The Mn-doped GaN substrate according to the first embodiment in the second aspect has the Ga polar (0001) surface 101 and the N polar (000-1) surface 102.

In the case where the Mn-doped GaN substrate includes the seed crystal layer and the Mn-doped layer, a surface of the first region 110 which is the Mn-doped layer is the (0001) surface 101, and a surface of the second region 120 which is the seed crystal layer is the (000-1) surface 102, as shown in FIG. 2.

In the case where the Mn-doped GaN substrate is formed of the Mn-doped GaN crystal, one surface of the Mn-doped layer is the (0001) surface 101 and the other surface is the (000-1) surface 102, as shown in FIG. 3.

A diameter of the Mn-doped GaN substrate is generally 20 mm or more, and may be any size such as 25 mm to 27 mm (about 1 inch), 50 mm to 55 mm (about 2 inches), 100 mm to 105 mm (about 4 inches), or 150 mm to 155 mm (about 6 inches).

A thickness t of the Mn-doped GaN substrate is set, according to the diameter, to a value at which handling of the Mn-doped GaN substrate is not difficult. For example, when the diameter of the Mn-doped GaN substrate is about 2 inches, the thickness of the Mn-doped GaN substrate is preferably 250 $\mu$m to 500 $\mu$m, and more preferably 300 $\mu$m to 450 $\mu$m.

In the case where the Mn-doped GaN substrate has a configuration in which the seed crystal layer and the Mn-doped layer are laminated as shown in FIG. 2, a thickness $t_1$ of the first region 110 which is the Mn-doped layer is preferably 80 $\mu$m to 200 $\mu$m, and more preferably 100 $\mu$m to 150 $\mu$m.

In two large-area surfaces of the Mn-doped GaN substrate, the (0001) surface 101 is used as a front surface for the epitaxial growth of a nitride semiconductor layer. The (0001) surface 101 is mirror-finished, and a root mean square (RMS) roughness thereof measured with an AFM is generally less than 2 nm, preferably less than 1 nm, and more preferably less than 0.5 nm in a measurement range of 2 $\mu$m $\times$ 2 $\mu$m.

The (000-1) surface 102 is a back surface, and therefore, the plane may be mirror-finished or rough-finished.

An edge of the Mn-doped GaN substrate may be chamfered.

The Mn-doped GaN substrate may be provided with various markings as necessary, such as orientation flats and notches for indicating an orientation of a crystal, and an index flat for facilitating the identification of a front surface and a back surface.

A shape of the Mn-doped GaN substrate is not particularly limited, and the shapes of the (0001) surface and the (000-1) surface may be a disk shape, a square shape, a rectangular shape, a hexagonal shape, an octagonal shape, an elliptical shape, or the like, or may be an irregular shape.

In the Mn-doped GaN substrate according to the first embodiment in the second aspect, the carrier mobility has a positive correlation with the temperature. In general, the carrier mobility of a semiconductor decreases as the temperature rises except for a low-temperature region of 300 K or lower. That is, the carrier mobility has a negative correlation with the temperature. The behavior of the carrier mobility can be explained by the theory that the higher the temperature is, the larger the lattice vibration of the crystal-forming atoms is, and the carrier is scattered to prevent the movement. On the other hand, the mechanism that the carrier mobility has a positive correlation with the temperature in a high-temperature region of 300 K or higher has not been theoretically clarified. It is extremely rare that the GaN crystal has a positive correlation at a high temperature of 650 K or higher. What is also surprising is an absolute value of the carrier mobility. It is surprising that a GaN crystal doped with an acceptor has a specific high carrier mobility of 50 cm$^2$/Vs or more even at 900 K. As mentioned above, carriers are affected by lattice scattering at a high temperature. For example, when there are various defects such as Ga holes, carriers are trapped, and the mobility decreases. The fact that the mobility increases with increasing temperature indicates that the positive effects of carriers outweigh the negative effects of lattice scattering and trapping.

Therefore, the fact that the carrier mobility has a positive correlation with the temperature and has a large absolute value is an index for determining the crystal quality. Examples of an index of the crystal quality of the GaN single crystal commonly known include the dislocation density or the like. However, even if the dislocation density is low, not all the GaN devices are necessarily operated satisfactorily. This is because carriers move perpendicularly to dislocations in, for example, a horizontal electronic device.

As described above, the temperature dependence of the carrier mobility more sensitively reflects the amount of microscopic defects in the GaN crystal of the semi-insulating substrate. Therefore, a GaN substrate having excellent crystal quality can be stably produced by focusing on the temperature dependence of the carrier mobility.

The carrier mobility is determined by the Hall effect measurement. The correlation between the carrier mobility and the temperature can be obtained by measuring the carrier mobility each time the sample temperature is changed. The temperature range for determining the correlation between the carrier mobility and the temperature is not particularly limited, and from the viewpoint of reliability of data, the temperature range is preferably determined as a range of 650 K or higher. The manganese-doped substrate has a very high specific resistance, and therefore, it is difficult to perform an accurate measurement at a temperature approaching room temperature. However, this is because the specific resistance decreases to a measurable range when the temperature is 650 K or higher.

The Mn-doped GaN substrate in which the carrier mobility has a positive correlation with the temperature can be obtained by, for example, a method for producing a Mn-doped GaN crystal described below.

In the Mn-doped GaN substrate according to the first embodiment in the second aspect, a ratio $\mu_H/\mu_L$ of carrier mobility $\mu_H$ at 800 K to carrier mobility $\mu_L$ at 650 K is preferably 1 or more. When the ratio $\mu_H/\mu_L$ of the carrier mobility $\mu_H$ at 800 K to the carrier mobility $\mu_L$ at 650 K is in the above range, the Mn-doped GaN substrate according to the first embodiment is excellent in the crystal quality of the GaN substrate, and is suitable as an SI substrate used for the GaN-HEMT.

The ratio $\mu_H/\mu_L$ of the carrier mobility $\mu_H$ at 800 K to the carrier mobility $\mu_L$ at 650 K is preferably 5 or more, more preferably 7 or more, and particularly preferably 10 or more. The upper limit is not particularly limited, and is generally 100 or less.

In the Mn-doped GaN substrate according to the first embodiment in the second aspect, the carrier mobility at 900 K is preferably 50 cm$^2$/Vs or more. When the carrier mobility at 900 K is in the above range, the Mn-doped GaN substrate according to the first embodiment is excellent in the crystal quality of the GaN substrate, and is suitable as an SI substrate used for the GaN-HEMT. The carrier mobility at 900 K is preferably 70 cm$^2$/Vs or more, more preferably 80 cm$^2$/Vs or more, and particularly preferably 100 cm$^2$/Vs or more. The upper limit is not particularly limited, and is generally 10000 cm$^2$/Vs or less.

In the Mn-doped GaN substrate according to the first embodiment in the second aspect, the carrier type is preferably p-type. In the case where the crystal quality of the GaN substrate is not good, electrons caused by impurities such as Si and O which are not intended are not sufficiently compensated even if doping with Mn is performed, and the GaN substrate tends to be n-type. Therefore, the p-type carrier means that the crystallinity of a GaN single crystal forming the GaN substrate is good. The carrier type can be experimentally determined using the Hall effect measurement.

The Mn-doped GaN substrate according to the first embodiment in the second aspect preferably has a specific resistance at 900 K of $5 \times 10^4$ Ωcm or more. When the specific resistance at 900 K is in the above range, the Mn-doped GaN substrate can be operated in a wide range of use environments without lowering the resistivity even when used in a high-temperature environment.

The specific resistance at 900 K is more preferably $1 \times 10^5$ Ωcm or more, still more preferably $2 \times 10^5$ Ωcm or more, and particularly preferably $5 \times 10^5$ Ωcm or more. In addition, the upper limit is not particularly limited because a higher specific resistance is more preferred.

A GaN substrate according to the second embodiment in the second aspect (Embodiment 2-2) is a GaN substrate doped with manganese, and a ratio $\mu_H/\mu_L$ of the carrier mobility $\mu_H$ at 800 K to the carrier mobility $\mu_L$ at 650 K is 1 or more.

Similarly to the first embodiment, in the GaN substrate according to the second embodiment in the second aspect, the resistance of the GaN crystal is increased by doping with Mn. When the ratio $\mu_H/\mu_L$ of the carrier mobility $\mu_H$ at 800 K to the carrier mobility $\mu_L$ at 650 K is 1 or more, the Mn-doped GaN substrate according to the second embodiment is excellent in crystal quality of the GaN substrate, and is suitable as an SI substrate used for a GaN-HEMT.

Similarly to the first embodiment, the GaN substrate according to the second embodiment in the second aspect may be a substrate formed only of the Mn-doped layer, or may be a substrate having a structure obtained by laminating the seed crystal layer and the Mn-doped layer.

The properties and characteristics of the Mn-doped GaN substrate according to the second embodiment in the second aspect are the same as the properties and characteristics of the Mn-doped GaN substrate according to the first embodiment.

In the Mn-doped GaN substrate according to the second embodiment in the second aspect, the ratio $\mu_H/\mu_L$ of the carrier mobility $\mu_H$ at 800 K to the carrier mobility $\mu_L$ at 650 K is 1 or more. When the ratio $\mu_H/\mu_L$ of the carrier mobility $\mu_H$ at 800 K to the carrier mobility $\mu_L$ at 650 K is in the above range, the Mn-doped GaN substrate according to the first embodiment is excellent in the crystal quality of the GaN substrate, and is suitable as an SI substrate used for the GaN-HEMT.

The ratio $\mu_H/\mu_L$ of the carrier mobility $\mu_H$ at 800 K to the carrier mobility $\mu_L$ at 650 K is preferably 5 or more, more preferably 7 or more, and particularly preferably 10 or more. The upper limit is not particularly limited, and is generally 100 or less.

In general, the carrier mobility of a GaN substrate doped with a compensation impurity decreases as the temperature rises except for a low-temperature region of 300 K or lower. Therefore, the ratio $\mu_H/\mu_L$ of the carrier mobility $\mu_H$ at 800 K to the carrier mobility $\mu_L$ at 650 K is less than 1. The behavior of the carrier mobility can be explained by the theory that the higher the temperature is, the larger the lattice vibration of the crystal-forming atoms is, and the carrier is scattered to prevent the movement. On the other hand, the reason why the ratio $\mu_H/\mu_L$ of the carrier mobility $\mu_H$ at 800 K to the carrier mobility $\mu_L$ at 650 K is 1 or more has not been theoretically clarified. It is extremely rare that the ratio $\mu_H/\mu_L$ of the carrier mobility $\mu_H$ at 800 K to the carrier mobility $\mu_L$ at 650 K of the GaN crystal is 1 or more. What is also surprising is the absolute value of the mobility. It is surprising that a GaN crystal doped with an acceptor has a specific high carrier mobility of 50 cm$^2$/Vs or more even at 900 K. As mentioned above, carriers are affected by lattice scattering at a high temperature. For example, when there are various defects such as Ga holes, carriers are trapped, and the mobility decreases. The fact that the mobility increases with increasing temperature indicates that the positive effects of carriers outweigh the negative effects of lattice scattering and trapping.

Therefore, the fact that the ratio $\mu_H/\mu_L$ of the carrier mobility $\mu_H$ at 800 K to the carrier mobility $\mu_L$ at 650 K is 1 or more and the fact that the carrier mobility has a large absolute value are an index for determining the crystal quality. Examples of an index of the crystal quality of the GaN single crystal commonly known include the dislocation density or the like. However, even if the dislocation density is low, not all the GaN devices are necessarily operated satisfactorily. This is because carriers move perpendicularly to dislocations in, for example, a horizontal electronic device.

As described above, the ratio $\mu_H/\mu_L$ of the carrier mobility $\mu_H$ at 800 K to the carrier mobility $\mu_L$ at 650 K more sensitively reflects the amount of microscopic defects and the like in the GaN crystal of the semi-insulating substrate. Therefore, a GaN substrate having excellent crystal quality can be stably produced by focusing on the ratio $\mu_H/\mu_L$ of the carrier mobility $\mu_H$ at 800 K to the carrier mobility $\mu_L$ at 650 K.

The layer structure, size, shape, carrier mobility, temperature dependence, carrier type, specific resistance, and the like of the Mn-doped GaN substrate according to the second embodiment in the second aspect are the same as the layer structure, size, shape, carrier mobility, temperature dependence, carrier type, specific resistance, and the like in the first embodiment, respectively.

In order to set the ratio $\mu_H/\mu_L$ of the carrier mobility $\mu_H$ at 800 K to the carrier mobility $\mu_L$ at 650 K of the GaN substrate to 1 or more, for example, a method for obtaining a GaN substrate by growing a Mn-doped GaN crystal by a method described below is exemplified.

A GaN substrate according to the third embodiment in the second aspect (Embodiment 2-3) is a GaN substrate doped with manganese, and the carrier type is p-type.

Similarly to the first embodiment, in the GaN substrate according to the third embodiment in the second aspect, the resistance of the GaN crystal is increased by doping with Mn. When the carrier type is p-type, the Mn-doped GaN substrate according to the third embodiment is excellent in crystal quality of the GaN substrate, and is suitable as an SI substrate used for a GaN-HEMT.

In the case where the crystal quality of the Mn-doped GaN substrate is not good, the carrier type tends to be n-type. This is considered to be because it is not possible to sufficiently compensate electrons caused by impurities such as Si and O which are not intended even if doping with Mn is performed. Therefore, the p-type carrier means that the crystallinity of the GaN single crystal forming the GaN substrate is good. Examples of an index of the crystal quality of the GaN single crystal commonly known include a dislocation density or the like, and the dislocation density does not necessarily reflect all the microscopic defects in the crystal. In particular, it is not necessarily suitable for determining the quality of the semi-insulating substrate. The semi-insulating property is an electrical property. However, when the dislocation density is equal to or less than a certain value, the electrical properties are not affected. On the other hand, the carrier type more sensitively reflects the electrical quality of the semi-insulating GaN crystal, and therefore, a GaN substrate having excellent crystal quality can be stably produced by focusing on the carrier type.

The carrier type can be experimentally determined using the Hall effect measurement.

The layer structure, size, shape, carrier mobility, and temperature dependence of the Mn-doped GaN substrate according to the third embodiment in the second aspect are the same as the layer structure, size, shape, carrier mobility, and temperature dependence in the first embodiment, respectively.

Similarly to the first embodiment and the second embodiment, the GaN substrate according to the third embodiment in the second aspect may be a substrate formed only of the Mn-doped layer, or may be a substrate having a structure obtained by laminating the seed crystal layer and the Mn-doped layer.

The properties and characteristics of the Mn-doped GaN substrate according to the third embodiment in the second aspect are the same as the properties and characteristics of the Mn-doped GaN substrate according to the first embodiment or the second embodiment.

A GaN substrate according to the fourth embodiment in the second aspect (Embodiment 2-4) is a semi-insulating GaN substrate, and the carrier mobility at 900 K is 50 cm$^2$/Vs or more. When the carrier mobility at 900 K of the GaN substrate is 50 cm$^2$/Vs or more, the GaN substrate is excellent in the crystal quality, and is suitable as an SI substrate used for the GaN-HEMT.

The carrier mobility at 900 K of the GaN substrate is more preferably 70 cm$^2$/Vs or more, still more preferably 80 cm$^2$/Vs or more, and particularly preferably 100 cm$^2$/Vs or more from the viewpoint that the crystal quality is better as the carrier mobility increases. The upper limit is not particularly limited, and the carrier mobility at 900 K is preferably 10000 cm$^2$/Vs or less.

In order to set the carrier mobility at 900 K of the GaN substrate to 50 cm$^2$/Vs or more, for example, a method for obtaining a GaN substrate by growing a Mn-doped GaN crystal by a method described below is exemplified.

The GaN substrate according to the fourth embodiment in the second aspect is a semi-insulating substrate. That is, the specific resistance at room temperature (300 K) is $1 \times 10^5$ Ωcm or more. The specific resistance at 900 K is preferably $1 \times 10^4$ Ωcm or more. When the specific resistance at 900 K is in the above range, the Mn-doped GaN substrate can be operated in a wide range of use environments without lowering the resistivity even when used in a high-temperature environment. The specific resistance at 900 K is more preferably $5 \times 10^4$ Ωcm or more, and still more preferably $1 \times 10^5$ Ωcm or more. In addition, the upper limit is not particularly limited because a higher specific resistance is preferred.

The GaN substrate according to the fourth embodiment in the second aspect may be a substrate formed of only a layer made of a GaN crystal, or may be a substrate obtained by laminating the seed crystal layer and the layer made of a GaN crystal.

Among them, the GaN substrate according to the fourth embodiment in the second aspect is preferably a GaN substrate doped with Mn. The Mn-doped GaN substrate can achieve both high resistance and excellent crystal quality of the GaN substrate.

The properties and characteristics of the Mn-doped GaN crystal in the GaN substrate according to the fourth embodiment in the second aspect are the same as the properties and characteristics of the Mn-doped GaN crystal in the first embodiment.

(Method for Producing GaN substrate)

The GaN substrates according to the first embodiment to the third embodiment in the first aspect (the embodiments 1-1 to 1-3) and the GaN substrates according to the first embodiment to the fourth embodiment in the second aspect (the embodiments 2-1 to 2-4) can be produced by, for example, a vapor phase growth method or a liquid phase growth method.

Examples of the vapor phase growth method is the HVPE method. Examples of the liquid phase growth method include an acidic ammonothermal method, a basic ammonothermal method, and a Na flux method. Among them, the HVPE method is preferred from the viewpoint of ease of production, and the ammonothermal method is preferred from the viewpoint of mass production and improvement in crystal quality.

Hereinafter, a method for producing a GaN substrate according to the present embodiment will be described using the HVPE method as an example.

The method for producing the GaN substrate according to the present embodiment based on the HVPE method preferably includes a first step shown in the following (i). This method is applied to production of a GaN substrate having a region on a N polarity side and a region on a Ga polarity side with a re-growth interface interposed therebetween, and more preferably, the specific resistance is increased in at least a part of the Ga polarity side.

(i) A first step of forming a GaN film by growing a (0001)-oriented thick GaN film on a c-plane GaN substrate seed by the HVPE method.

In this description, the term "on the substrate" has the same meaning as the term "on the surface of the substrate".

Hereinafter, the above first step will be described in more detail.

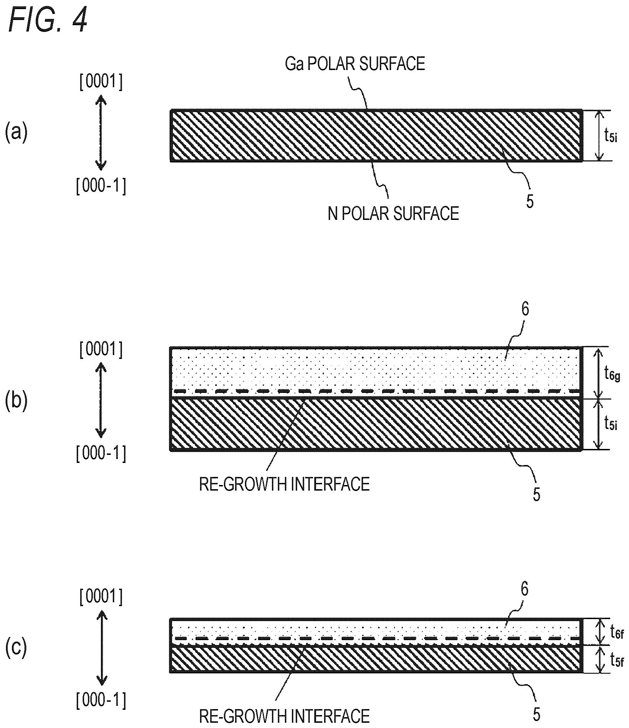

In the first step, as shown in (a) and (b) of FIG. 4, a (0001)-oriented GaN layer 6 is grown on a Ga polar surface of a c-plane GaN substrate seed 5 by the HVPE method to obtain a GaN substrate as a laminated structure. A growth thickness $t_{6g}$ of the GaN layer 6 is preferably more than 50 μm. At this time, a re-growth interface is formed between the c-plane GaN substrate seed 5 and the GaN layer 6.

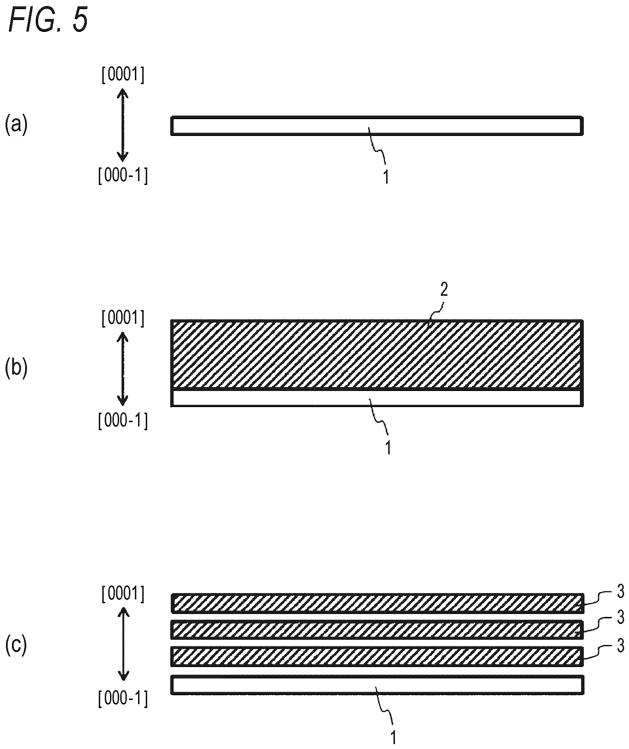

The method for obtaining the c-plane GaN substrate seed used in the above first step is not particularly limited. For example, after a seed wafer 1 shown in (a) of FIG. 5 is prepared, a (0001)-oriented thick GaN film 2 made of GaN that is not intentionally doped is grown on the seed wafer 1 by the HVPE method as shown in (b) of FIG. 5. As shown in (c) of FIG. 5, at least one c-plane GaN substrate seed 3, which is a substrate, can be obtained by processing the thick GaN film 2. An example of the seed wafer 1 is a c-plane sapphire wafer, and the seed wafer 1 is preferably provided with a release layer on a main surface thereof. A thick GaN film is further grown by the HVPE method on the thus obtained c-plane GaN substrate seed 3, and the c-plane substrate obtained by the processing may be used as the c-plane GaN substrate seed used for the above-described first step.

Generally, the Ga polar surface of the GaN substrate seed 5 is subjected to a flattening step, that is, a step of processing the Ga polar surface into a flat surface by appropriately using a technique such as grinding, polishing, or a processing technique using a chemical polishing agent and a polishing pad called CMP before growing the GaN layer 6. The flattened Ga polar surface may be subjected to a roughening step, that is, a step of processing into a rough surface by etching, and then the GaN layer 6 may be grown.

In the first step, at least a part of the GaN layer 6 is doped with Mn that is a compensation impurity.

It should be noted that doping with Fe or C as a compensation impurity in addition to Mn is not excluded.

The doping with Mn can be performed by a commonly known method, and for example, the HVPE method is preferred. In the case where the HVPE method is used, examples of the raw gas include manganese dichloride and manganese vapor, and manganese dichloride is more preferred from the viewpoint of stable crystal growth. In the case where manganese dichloride is used, GaN crystals with more excellent crystal quality can be obtained.

In the case where manganese dichloride is used as the raw gas, a growth rate is preferably 20 $\mu$m/hr or more from the viewpoint of high productivity, and is preferably 100 $\mu$m/hr or less from the viewpoint of stable crystal growth.

The partial pressure of the manganese dioxide is adjusted such that the aforementioned manganese concentration is reached.

The growth thickness $t_{6g}$ of the GaN layer 6 may be set according to a design thickness of the Ga polarity side region of the GaN substrate to be produced.

In the GaN substrate, even if the diameter of the wafer is 4 inches or 6 inches, the growth thickness $t_{6g}$ of the GaN layer 6 can be reduced to 500 $\mu$m or less.

After the first step, as illustrated in (c) of FIG. 4, a thinning step of thinning the GaN layer 6 that is the laminated structure is provided as necessary.

In (c) of FIG. 4, a thickness of the GaN substrate seed 5 is reduced from an initial thickness $t_{5i}$ to a final thickness $t_{5f}$, and a thickness of the GaN layer 6 is reduced from an initial thickness $t_{6i}$ to a final thickness ter. Alternatively, in the thinning step, only either one of the GaN substrate seed 5 and the GaN layer 6 may be processed.

When the off-cut orientation of the GaN substrate to be produced and the off-cut of the GaN substrate seed 5 are the same, a back surface of the GaN substrate seed 5 (the N-polar surface of the laminated structure) can be used as a reference of the plane orientation during the thinning process.

When the off-cut orientation of the GaN substrate to be produced is different from the off-cut of the GaN substrate seed 5, that is, at least one of an off-cut angle and an off-cut direction is different, a crystal orientation of the GaN layer to be the laminated structure is checked by an X-ray diffraction device before the thinning process.

The processing technique used in the thinning step can be appropriately selected from grinding, lapping, CMP, dry etching, wet etching, and the like.

The GaN substrate according to the present embodiment can be produced with a good yield by using the production method described above.

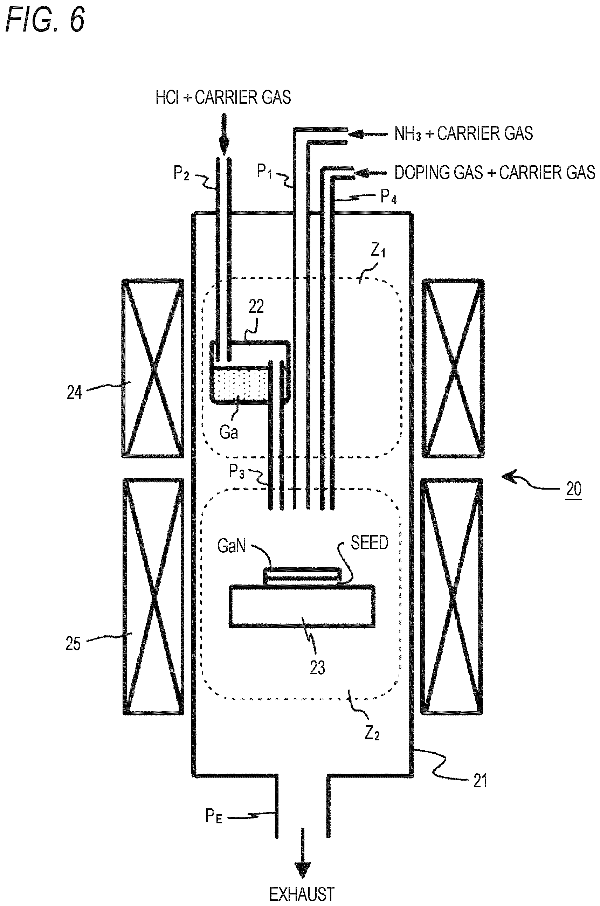

Next, an example of an HVPE device that can be used in the first step of the above-described production method will be described below with reference to FIG. 6.

An HVPE device 20 shown in FIG. 6 includes a hot-wall reactor 21, a gallium reservoir 22 and a susceptor 23 disposed in the reactor, and a first heater 24 and a second heater 25 disposed outside the reactor. The first heater 24 and the second heater 25 each annularly surround the reactor 21.

The reactor 21 is a quartz tube chamber. The reactor 21 includes a first zone Z1 mainly heated by the first heater 24 and a second zone Z2 mainly heated by the second heater 25. An exhaust pipe PE is connected to a reactor end on a second zone Z2 side.

The gallium reservoir 22 disposed in the first zone Z1 is a quartz container having a gas inlet and a gas outlet.

The susceptor 23 disposed in the second zone Z2 is formed of, for example, graphite. A mechanism for rotating the susceptor 23 may be freely provided.

In order to grow GaN by the HVPE device 20, a seed is placed on the susceptor 23, and an inside of the reactor 21 is heated by the first heater 24 and the second heater 25. At the same time, $NH_3$ (ammonia) diluted with a carrier gas is supplied to the second zone Z2 through an ammonia introduction pipe P1, and HCl (hydrogen chloride) diluted with a carrier gas is supplied to the gallium reservoir 22 through a hydrogen chloride introduction pipe P2. HCl reacts with the metallic gallium in the gallium reservoir 22, and the generated GaCl (gallium chloride) is carried to the second zone Z2 through a gallium chloride introduction pipe P3.

$NH_3$ reacts with GaCl in the second zone Z2, and the generated GaN is crystallized on the seed placed on the

**EP 4 484 621 A1**

susceptor 23.

When growing GaN is to be intentionally doped, a doping gas diluted with a carrier gas is guided to the second zone Z2 in the reactor 21 through a dopant introduction pipe P4.

Portions of the ammonia introduction pipe P1, the hydrogen chloride introduction pipe P2, the gallium chloride introduction pipe P3, and the dopant introduction pipe P4 disposed in the reactor 11 are formed of quartz.

As the carrier gas for diluting each of $NH_3$, HCl, and the doping gas, $H_2$ (hydrogen gas), $N_2$ (nitrogen gas), or a mixed gas of $H_2$ and $N_2$ is preferably used.

Preferred conditions for growing GaN using the HVPE device 20 are as follows.

The temperature of the gallium reservoir is, for example, 500°C to 1000°C, and preferably 700°C or higher, and is preferably 900°C or lower.

The susceptor temperature is, for example, 900°C to 1100°C, preferably 930°C or higher, and more preferably 950°C or higher, and is preferably 1050°C or lower, and more preferably 1020°C or lower.

The V/III ratio, which is a ratio of the $NH_3$ partial pressure to the GaCl partial pressure in the reactor, is, for example, 1 to 20, preferably 2 or more, and more preferably 3 or more, and is preferably 10 or less.

An excessively small or excessively large V/III ratio causes the morphology of the GaN growth surface to deteriorate. Deterioration in the morphology of the growth surface may cause deterioration in the crystal quality.

In a certain type of impurity, the incorporation efficiency into the GaN crystal strongly depends on the crystal orientation of the growth surface. In the GaN crystal grown under the condition that the morphology of the growth surface is not good, the uniformity of the concentration of the impurities is reduced. This is because the growth surface with poor morphology has a variety of facets in various orientations.

A typical example of impurities whose incorporation efficiency into the GaN crystal is clearly different depending on the crystal orientation of the growth surface is O (oxygen). A decrease in the uniformity of the concentration of O leads to a decrease in the uniformity of the specific resistance because O is a donor impurity.

In addition, the use of an excessively low V/III ratio increases a nitrogen vacancy concentration of the growing GaN crystal. The effect of nitrogen vacancies on GaN crystals, GaN substrates using such crystals, and nitride semiconductor devices formed on such GaN substrates is not clear, and it is considered that the concentration is to be reduced as much as possible because the nitrogen vacancies are point defects.

The growth rate of GaN is preferably 40 $\mu$m/h to 200 $\mu$m/h, and can be controlled using the product of the $NH_3$ partial pressure and the GaCl partial pressure in the reactor as a parameter. An excessively high growth rate causes the surface morphology of growing GaN to deteriorate.

When the GaN layer 6 is doped in the aforementioned first step, it is preferable to gradually increase a supply rate of the doping gas to a predetermined value over several minutes or several tens of minutes from the start of the supply in order to prevent deterioration in morphology of the growth surface.

For the same reason, the supply of the doping gas is preferably started at a time point when the GaN layer 6 is grown by at least several micrometers. Specifically, when the GaN layer is formed in the first step, the doping gas is not supplied when the thickness of the GaN layer is at least 5 $\mu$m or more, preferably at least 10 $\mu$m or more in the initial stage of growth of the GaN layer, and the GaN layer is preferably grown as an undoped layer. Accordingly, no new dislocation occurs at an interface between the undoped layer and the doped layer, and the quality of the seed crystal can be maintained.

A method for causing the GaN layer 6 to contain a compensation impurity such as Mn is not limited, and a method for introducing a doping gas into the HVPE device is generally adopted.

The doping gas for doping with Mn is as described above. For example, in the case where manganese dichloride is used as the raw gas, the metallic Mn may be placed in an introduction tube, and the manganese dichloride gas may be prepared on the spot by heating the metal Mn and using the flow of the hydrogen chloride gas. When the manganese dichloride gas is prepared on the spot in this manner, a contact area between the metallic Mn and the hydrogen chloride gas is preferably increased so that the concentration of the manganese dichloride gas is uniform. For example, the metallic Mn is finely crushed so as to have a diameter of several millimeters, packed in a quartz pipe, and diluted hydrogen chloride gas is allowed to flow through the quartz pipe, so that the gas/solid contact area can be increased. This is preferable because the uniformity of the crystal quality of the Mn-doped GaN crystal can be improved.

When the undoped layer is continuously doped with Mn, the hydrogen chloride concentration is preferably gradually increased. By gradually increasing the hydrogen chloride concentration, formation of a steep interface between the undoped layer and the manganese-doped layer in the crystal can be prevented, and therefore, the crystal quality is improved. Specifically, it is desirable to linearly increase the hydrogen chloride concentration required for the desired manganese doping concentration over 3 minutes or longer. When an interface between the undoped layer and the manganese-doped layer having a steep Mn concentration is generated in the crystal, the crystal quality may deteriorate. By adopting such a method, the quality of the Mn-doped crystal can be improved. A ratio of a Mn concentration at a position 10 $\mu$m away from the interface between the undoped layer and the manganese-doped layer in the [0001] direction to a Mn concentration at the interface between the undoped layer and the manganese-doped layer in the crystal is preferably 2

**15**

times or more, or may be 5 times or more. In this case, it means that the concentration gradient in the GaN crystal around the interface between the undoped layer and the manganese-doped layer is not steep but changes gradually.

In the case where Fe is introduced in addition to Mn as a compensation impurity, for example, vaporized iron chloride may be used as a doping gas for doping with Fe. The iron chloride vapor may be generated by a method in which HCl is brought into contact with metallic iron heated under a carrier gas flow, or a method in which ferrocene (bis(cyclopentadienyl)iron) vaporized by heating under a carrier gas flow reacts with HCl in a dopant introduction pipe. Here, ferrocene may be substituted with another organic compound containing iron.

When another transition metal element is added to GaN, a vapor of the transition metal element or a vapor of a chloride of the transition metal element can also be used as a doping gas.

The GaN grown using the HVPE device 20 can contain O and Si at a concentration detectable by secondary ion mass spectrometry (SIMS) even when the GaN is not intentionally doped with O and Si.

The Si source is quartz ($SiO_2$) used for a reactor or a pipe in the reactor, and the O source is either one or both of the quartz and moisture remaining or entering the reactor.

The components disposed in the reactor 21, including components not shown in FIG. 6, may be those formed of SiC (silicon carbide), SiNx (silicon nitride), BN (boron nitride), alumina, W (tungsten), Mo (molybdenum), or the like, in addition to quartz and carbon. By doing so, the concentration of impurity elements other than Si, O, and H in GaN grown using the HVPE device 20 can be independently set to $5 \times 10^{15}$ atoms/cm$^3$ or less unless intentional doping is performed.

An example of a method for producing a GaN substrate that is a laminated structure has been described as the method for producing a GaN substrate according to the present embodiment, and the GaN substrate is not limited to the GaN substrate that is a laminated structure.

For example, such a GaN substrate can also be obtained by growing the GaN layer 6 to have a thickness equal to or larger than a certain thickness to form a thick GaN film and slicing a GaN substrate which is a c-plane GaN substrate from the thick GaN film in the above-described first step. At this time, the obtained GaN substrate is formed only of the above-described GaN layer 6.

In the case where the above specific doped region having a high Mn concentration is selected as a region to be sliced in the GaN substrate which is a c-plane GaN substrate, the Mn concentration of all regions in the obtained GaN substrate is increased. That is, a GaN substrate including only the specific doped region without the GaN substrate seed 5 can be obtained.

(Use of GaN Substrate)

The GaN substrate according to the present invention can be preferably used for producing a nitride semiconductor device, particularly a nitride semiconductor device having a horizontal device structure. Specifically, the nitride semiconductor device can be produced by a method including a step of preparing the above GaN substrate and a step of epitaxially growing one or more nitride semiconductor layers on the prepared substrate.

The nitride semiconductor is also referred to as a nitride-based Group III-V compound semiconductor, a group III nitride-based compound semiconductor, a GaN-based semiconductor, or the like, and includes not only GaN but also a compound obtained by substituting a part or all of gallium of GaN with other Group 13 elements (B, Al, In, or the like) of the periodic table.

A typical example of the nitride semiconductor device having a horizontal device structure is a GaN-HEMT, and the horizontal device structure may be adopted in an electronic device other than the HEMT such as a bipolar transistor, or in a light-emitting device such as a light-emitting diode (LED) or a laser diode (LD).

Examples

The present invention will be described in detail below with reference to Examples, but the present invention is not limited to thereto.

<Test Example 1>

(Example 1-1)

1. Epitaxial growth of GaN crystal

Using a vapor phase growth device equipped with a quartz hot wall reactor, a GaN crystal was epitaxially grown on a free-standing GaN seed having a diameter of 62 mm and a thickness of 400 $\mu$m by the HVPE method.

In this step, (1) a temperature increase step, (2) a GaN layer growth step, and (3) a cooling step described below were sequentially performed.

(1) Temperature Increase Step

First, a free-standing GaN seed was placed in a reactor.

Next, a reactor temperature was increased from room temperature to 985°C while supplying ammonia and a carrier gas to the free-standing GaN seed. Hydrogen gas and nitrogen gas were used as the carrier gas. With this step, a GaN substrate seed was obtained.

(2) Mn-doped GaN Layer Growth Step

A mixed gas containing ammonia and gallium chloride as shown in the following growth conditions was supplied as a raw gas while maintaining the reactor temperature at 1000°C, thereby growing a Mn-doped GaN layer on the GaN substrate seed to have a thickness of 400 $\mu$m.

The growth rate was 50 $\mu$m/hr, and the growth conditions were as follows: a reactor pressure of 101 kPa; an ammonia partial pressure of 3.172 kPa; a GaCl partial pressure of 0.847 kPa; a hydrogen gas partial pressure of 43.4 kPa; and a nitrogen gas partial pressure of 55.581 kPa; and a manganese dichloride partial pressure of $5.37 \times 10^{-4}$ kPa.

For the initial 30 minutes of growth, manganese dichloride was not passed through to produce the undoped layer, and after 30 minutes, diluted hydrogen chloride gas was passed through metallic Mn heated to 800°C to generate manganese dichloride.

Here, the concentration of diluted hydrochloric acid hydrogen chloride was linearly increased from 0 volume% to 0.023 volume% over 10 minutes so as not to form a steep interface between the undoped layer and the Mn-doped layer.

Accordingly, it was confirmed that the dislocation density of the Mn-doped layer was almost the same as the dislocation density of the seed, and new dislocations were not generated at the interface between the undoped layer and the Mn-doped layer.

In addition, the metallic Mn is finely crushed so as to have a diameter of several millimeters, packed in a quartz pipe, and diluted hydrogen chloride gas is allowed to flow through the quartz pipe, so that the gas/solid contact area was increased.

The gas partial pressure ($P_G$) here is a value obtained by multiplying the reactor pressure ($P_R$) by a ratio (r) of a volume flow rate of the gas to a total volume flow rate of all the gases supplied into the reactor, that is, a value represented by $P_G = r \times P_R$.

Next, the reactor temperature was increased to 1010°C while continuously supplying the raw gas and the carrier gas.

(3) Cooling Step

After completion of the Mn-doped GaN layer growth step described in the above (2), the supply of gallium chloride to the GaN substrate seed was stopped, and the heating for the reactor was stopped to lower the reactor temperature to room temperature. The gas flowing into the reactor was ammonia and nitrogen gas until the temperature decreased to 600°C, and then only nitrogen gas was used.

The surface of the as-grown GaN crystal taken out from the reactor was a mirror surface over the entire surface and was flat.

2. Production of c-Plane GaN Substrate

The as-grown GaN crystal obtained in the above 1. was subjected to laser coring to obtain a square epitaxial substrate having a side of 7 mm. Next, lapping and polishing of the +c-plane and the -c-plane were sequentially performed to complete a c-plane GaN substrate doped with Mn. Thereafter, the seed portion on the -c plane was completely removed.

The total thickness of the c-plane GaN substrate was 300 $\mu$m, and the entire substrate was formed of the Mn-doped layer.

3. Evaluation of c-Plane GaN Substrate

<Measurement of Mn Concentration>

The Mn concentration of the c-plane GaN substrate was measured by SIMS.

As a result, the Mn concentration was $8 \times 10^{17}$ atoms/cm$^3$.

<Measurement of Carrier Concentration, Specific Resistance, and Carrier Type>

Next, for the Hall effect measurement, Ti 30 nm and Au 100 nm were continuously vacuum-deposited on a surface of the c-plane GaN substrate. In the Hall effect measurement, a 4-terminal vnv der Pauw method was used. In the Hall effect measurement, the carrier concentration, the specific resistance, and the carrier type were measured while changing the measurement temperature.

The measurement results of the carrier concentration are shown in FIG. 7. In the graph of FIG. 7, 1000/T (1/K) is plotted on the x-axis, and the carrier concentration (atoms/cm$^3$) is plotted on the y-axis.

The carrier concentration was increased with an increase in the temperature, and when the carrier concentration was fitted by the following formula (I), the activation energy Ea of the carrier was 0.952 eV ([Mn] = 8E17 ($8 \times 10^{17}$) cm$^{-3}$).

$$\text{carrier concentration (atoms/cm}^3) = A \times \text{EXP}(\text{-Ea/kT}) \qquad \text{(I)},$$

(In the formula (I), A represents a proportional constant, EXP represents an exponential function, Ea represents a carrier activation energy (eV), k represents a Boltzmann constant ($8.617 \times 10^{-5}$ eV/K), and T represents a temperature (K) in Kelvin units.). The determination coefficient $R^2$ in exponential approximation was 0.9266.

The measurement results of specific resistance are shown in FIG. 8. From the results of FIG. 8, it was found that the specific resistance at 900 K was $5 \times 10^4$ Ωcm or more.

The carrier type determined by the Hall effect measurement in all temperature ranges was p-type.

The above evaluation shows that the c-plane GaN substrate of Example 1 has a very large activation energy Ea, and this large value is considered to contribute to a large specific resistance of the Mn-doped GaN substrate.

<Measurement of Dislocation Density>

The dislocation density of the c-plane GaN substrate was measured by the CL method. The c-plane GaN substrate for the CL measurement was prepared separately from the substrate for the Hall effect measurement. This is because the light emission in a vicinity of a band edge of the Mn-doped substrate is extremely weak, and thus dislocations cannot be observed as dark spots. After the Mn-doped GaN layer was grown to a thickness of 400 μm by the methods in the above "1. Epitaxial Growth of GaN Crystal" and "2. Fabrication of c-Plane GaN Substrate", only the manganese dichloride gas was turned off to continuously grow the undoped GaN layer to a thickness of 50 μm. The cooling step and the like are the same as the above. The obtained c-plane GaN substrate for the CL measurement was subjected to CL measurement in the as-grown form. If the dislocation density is increased in the Mn-doped layer, the dislocation density is to be similarly increased in the GaN layer grown on the Mn-doped layer. Therefore, this method is appropriate for evaluating the dislocation density of the Mn-doped layer. The dislocation density was evaluated by measuring the number of dark spots by CL observation at 3 kV, 100 pA, and 1000x magnification, and calculating the density.

As a result, the dislocation density was $8 \times 10^5$ cm$^{-2}$, which was equivalent to that of the seed used. This indicates that dislocations were not increased by doping with Mn.

<Test Example 2>

(Example 2-1)

1. Epitaxial growth of GaN crystal

Using a vapor phase growth device equipped with a quartz hot wall reactor, a GaN crystal was epitaxially grown on a free-standing GaN seed having a diameter of 62 mm and a thickness of 400 μm by the HVPE method.

In this step, (1) a temperature increase step, (2) a GaN layer growth step, and (3) a cooling step described below were sequentially performed.

(1) Temperature Increase Step

First, a free-standing GaN seed was placed in a reactor.

Next, a reactor temperature was increased from room temperature to 985°C while supplying ammonia and a carrier gas to the free-standing GaN seed. Hydrogen gas and nitrogen gas were used as the carrier gas. With this step, a GaN substrate seed was obtained.

(2) Mn-doped GaN Layer Growth Step

A mixed gas containing ammonia and gallium chloride as shown in the following growth conditions was supplied as a raw gas while maintaining the reactor temperature at 1000°C, thereby growing a Mn-doped GaN layer on the GaN substrate seed to have a thickness of 400 $\mu$m.

The growth rate was 50 $\mu$m/hr, and the growth conditions were as follows: a reactor pressure of 101 kPa; an ammonia partial pressure of 3.172 kPa; a GaCl partial pressure of 0.847 kPa; a hydrogen gas partial pressure of 43.4 kPa; and a nitrogen gas partial pressure of 55.581 kPa; and a manganese dichloride partial pressure of $5.37 \times 10^{-4}$ kPa.

For the initial 30 minutes of growth, manganese dichloride was not passed through to produce the undoped layer, and after 30 minutes, diluted hydrogen chloride gas was passed through metallic Mn heated to 800°C to generate manganese dichloride.

Here, the concentration of diluted hydrochloric acid hydrogen chloride was linearly increased from 0 volume% to 0.023 volume% over 10 minutes so as not to form a steep interface between the undoped layer and the Mn-doped layer.

Accordingly, it was confirmed that the dislocation density of the Mn-doped layer was almost the same as the dislocation density of the seed, and new dislocations were not generated at the interface between the undoped layer and the Mn-doped layer.

In addition, the metallic Mn is finely crushed so as to have a diameter of several millimeters, packed in a quartz pipe, and diluted hydrogen chloride gas is allowed to flow through the quartz pipe, so that the gas/solid contact area was increased.

The gas partial pressure ($P_G$) here is a value obtained by multiplying the reactor pressure ($P_R$) by a ratio (r) of a volume flow rate of the gas to a total volume flow rate of all the gases supplied into the reactor, that is, a value represented by $P_G = r \times P_R$.

Next, the reactor temperature was increased to 1010°C while continuously supplying the raw gas and the carrier gas.

(3) Cooling Step

After completion of the Mn-doped GaN layer growth step described in the above (2), the supply of gallium chloride to the GaN substrate seed was stopped, and the heating for the reactor was stopped to lower the reactor temperature to room temperature. The gas flowing into the reactor was ammonia and nitrogen gas until the temperature decreased to 600°C, and then only nitrogen gas was used.

The surface of the as-grown GaN crystal taken out from the reactor was a mirror surface over the entire surface and was flat.

2. Production of c-Plane GaN Substrate

The as-grown GaN crystal obtained in the above 1. was subjected to laser coring to obtain a square epitaxial substrate having a side of 7 mm. Next, lapping and polishing of the +c-plane and the -c-plane were sequentially performed to complete a c-plane GaN substrate doped with Mn. Thereafter, the seed portion on the -c plane was completely removed.

The total thickness of the c-plane GaN substrate was 300 $\mu$m, and the entire substrate was formed of the Mn-doped layer.

3. Evaluation of c-Plane GaN Substrate

<Measurement of Mn Concentration>

The Mn concentration of the c-plane GaN substrate was measured by SIMS.

As a result, the Mn concentration was $9 \times 10^{18}$ atoms/cm$^3$.

<Measurement of Carrier Mobility and Carrier Type>

For the Hall effect measurement, Ti 30 nm and Au 100 nm were continuously vacuum-deposited on a surface of the c-plane GaN substrate. In the Hall effect measurement, a 4-terminal van der Pauw method was used. In the Hall effect measurement, the carrier mobility and the carrier type were measured while changing the measurement temperature.

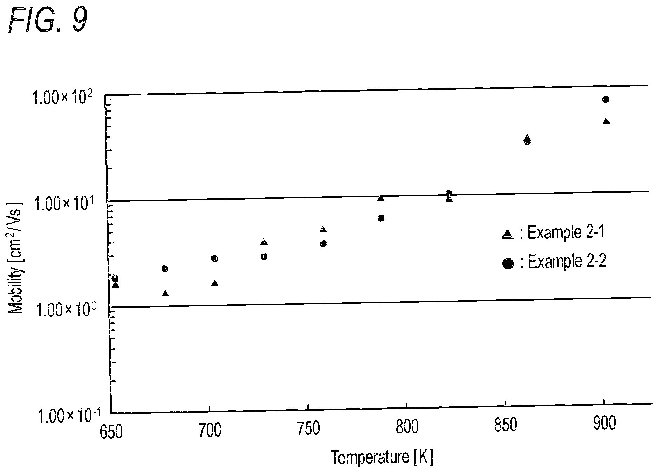

The measurement results of the carrier mobility are shown in FIG. 9. In the graph of FIG. 9, the temperature (K) is plotted on the x-axis, and the carrier mobility (cm$^2$/Vs) is plotted on the y-axis.

<Measurement of Dislocation Density>

The dislocation density of the c-plane GaN substrate was measured by the CL method. The c-plane GaN substrate for the CL measurement was prepared separately from the substrate for the Hall effect measurement. This is because the light emission in a vicinity of a band edge of the Mn-doped substrate is extremely weak, and thus dislocations cannot be observed as dark spots. After the Mn-doped GaN layer was grown to a thickness of 400 $\mu$m by the methods in the above "1. Epitaxial Growth of GaN Crystal" and "2. Fabrication of c-Plane GaN Substrate", only the manganese dichloride gas was turned off to continuously grow the undoped GaN layer to a thickness of 50 $\mu$m. The cooling step and the like are the same as the above. The obtained c-plane GaN substrate for the CL measurement was subjected to CL measurement in the as-grown form. If the dislocation density is increased in the Mn-doped layer, the dislocation density is to be similarly increased in the GaN layer grown on the Mn-doped layer. Therefore, this method is appropriate for evaluating the dislocation density of the Mn-doped layer. The dislocation density was evaluated by measuring the number of dark spots by CL observation at 3 kV, 100 pA, and 1000x magnification, and calculating the density.

As a result, the dislocation density was $8 \times 10^5$ cm$^{-2}$, which was equivalent to that of the seed used. This indicates that dislocations were not increased by doping with Mn.

(Example 2-2)

A c-plane GaN substrate was produced and evaluated in the same manner as in Example 2-1 except that the Mn doping concentration in Example 2-1 was changed.

As a result, the Mn concentration was $1 \times 10^{19}$ atoms/cm$^3$, and the dislocation density was $8 \times 10^5$ cm$^{-2}$.

The results of measuring the carrier mobility are shown in FIG. 9.

In both Examples 2-1 and 2-2, the temperature range in which stable measurement results of carrier mobility were obtained was 650 K or higher. In this range, the carrier mobility has a positive correlation with the temperature in both Examples. The ratio $\mu_H/\mu_L$ of the carrier mobility $\mu_H$ at 800 K to the carrier mobility $\mu_L$ at 650 K was 1 or more. In each of Examples, the carrier type by the Hall effect measurement in all temperature ranges was p-type.

Generally, in a GaN crystal, the mobility has a negative correlation with the temperature in a temperature range of 400 K or higher. This is due to the lattice scattering mechanism of carrier mobility. Accordingly, the temperature dependence of the carrier mobility of the Mn-doped GaN substrate obtained in this experiment is very specific, and this indicates that the crystal quality of the Mn-doped GaN substrate is very excellent.

Although the present invention has been described in detail with reference to the specific embodiment, it will be apparent to those skilled in the art that various changes and modifications can be made without departing from the spirit and scope of the present invention. The present application is based on Japanese Patent Applications (No. 2022-026202 and No. 2022-026203) filed on February 22, 2022, contents of which are incorporated herein by reference.

REFERENCE SIGNS LIST

1 seed wafer
2 thick GaN film
3 c-plane GaN substrate seed
5 c-plane GaN substrate seed
6 GaN layer
10 Mn-doped GaN crystal
11 (0001) surface
20 HVPE device
21 reactor
22 gallium reservoir
23 susceptor
24 first heater
25 second heater
100 Mn-doped GaN substrate
101 (0001) surface
102 (000-1) surface
110 first region
120 second region

**Claims**

1. A GaN substrate doped with manganese, wherein an activation energy of a carrier is 0.7 eV or more when a carrier concentration is represented by the following formula (I):

$$\text{carrier concentration (atoms/cm}^3) = A \times EXP(-Ea/kT) \quad (I),$$

in which A represents a proportional constant, EXP represents an exponential function, Ea represents a carrier activation energy (eV), k represents a Boltzmann constant ($8.617 \times 10^{-5}$ eV/K), and T represents a temperature (K) in Kelvin units.

2. The GaN substrate according to claim 1, wherein the activation energy Ea of the carrier is 0.7 eV to 1.2 eV

3. The GaN substrate according to claim 1, wherein the activation energy Ea of the carrier is determined by a least squares method, and a determination coefficient $R^2$ of an approximation curve when performing exponential approximation by the least squares method is 0.9 or more.

4. The GaN substrate according to claim 1, wherein the activation energy Ea of the carrier is obtained by fitting a carrier concentration measured by changing a temperature in a temperature range of 450 K to 950 K at intervals of 50 K to the formula (I).

5. A GaN substrate doped with manganese, wherein a carrier concentration at 900 K is less than $1 \times 10^{13}$ atoms/cm$^3$.

6. A GaN substrate, which has a specific resistance at 900 K of $5 \times 10^4$ Ωcm or more.

7. The GaN substrate according to claim 6, which is doped with manganese.

8. The GaN substrate according to any one of claims 1 to 7, wherein a type of the carrier is p-type.

9. The GaN substrate according to any one of claims 1 to 8, wherein a dislocation density is $1 \times 10^6$ cm$^{-2}$ or less.

10. A GaN substrate doped with manganese, wherein carrier mobility has a positive correlation with temperature.

11. A GaN substrate doped with manganese, wherein a ratio $\mu_H/\mu_L$ of carrier mobility $\mu_H$ at 800 K to carrier mobility $\mu_L$ at 650 K is 1 or more.

12. A GaN substrate doped with manganese, wherein a type of a carrier is p-type.

13. A GaN substrate, which is a semi-insulating GaN substrate, wherein carrier mobility at 900 K is 50 cm$^2$/Vs or more.

14. The GaN substrate according to claim 13, which is doped with manganese.

15. The GaN substrate according to any one of claims 10 to 14, wherein a dislocation density is $1 \times 10^6$ cm$^{-2}$ or less.

*FIG. 1*

*FIG. 2*

*FIG. 3*

## FIG. 4

(a)

[0001]

[000-1]

Ga POLAR SURFACE

N POLAR SURFACE

$t_{5i}$

5

(b)

[0001]

[000-1]

6

$t_{6g}$

$t_{5i}$

RE-GROWTH INTERFACE

5

(c)

[0001]

[000-1]

6

$t_{6f}$

$t_{5f}$

RE-GROWTH INTERFACE

5

## FIG. 5

(a)

[0001]

[000-1]

1

(b)

[0001]

[000-1]

2

1

(c)

[0001]

[000-1]

3

3

3

1

*FIG. 6*

*FIG. 7*

*FIG. 8*

FIG. 9

<div align="center">

**INTERNATIONAL SEARCH REPORT**

</div>

| | International application No. |
|---|---|
| | **PCT/JP2023/006086** |

| A. | CLASSIFICATION OF SUBJECT MATTER |
|---|---|

*C30B 29/38*(2006.01)i; *C23C 16/34*(2006.01)i; *C30B 25/20*(2006.01)i; *H01L 21/205*(2006.01)i
FI:   C30B29/38 D; C23C16/34; C30B25/20; H01L21/205

According to International Patent Classification (IPC) or to both national classification and IPC

| B. | FIELDS SEARCHED |
|---|---|

Minimum documentation searched (classification system followed by classification symbols)

C30B29/38; C23C16/34; C30B25/20; H01L21/205

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

CAplus/REGISTRY (STN)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | BOCKOWSKI et al. Doping in bulk HVPE-GaN grown on native seeds highly conductive and semi-insulating crystals. Journal of Crystal Growth, 2018, vol. 499, pp. 1-7<br>abstract, p. 6, left column, line 13 to right column, fig. 6 | 1, 3-7, 9 |
| A | | 2, 8, 10-15 |
| X | IWINSKA et al. Crystallization of semi-insulating HVPE-GaN with solid iron as a source of dopants. Journal of Crystal Growth, 2017, vol. 475, pp.121-126<br>abstract, p. 122, left column to p. 125, right column, table 2, fig. 3 | 1, 3-7, 9 |
| A | | 2, 8, 10-15 |
| X | ZAJAC et al. p-type conductivity in GaN:Zn monocrystals grown by ammonothermal method. Journal of Applied Physics, 2021, vol. 129, 135702<br>abstract, p. 2, left column to p. 6, table 1, fig. 5 | 10, 12, 15 |
| A | | 1-9, 11, 13-14 |

☑ Further documents are listed in the continuation of Box C.　　　☐ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **10 April 2023** | **25 April 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

International application No.

**PCT/JP2023/006086**

### C. DOCUMENTS CONSIDERED TO BE RELEVANT

| Category* | Citation of document, with indication, where appropriate, of the relevant passages | Relevant to claim No. |
|---|---|---|
| X | IWINSKA et al. Iron and manganese as dopants used in the crystallization of highly resistive HVPE-GaN on native seeds. Japanese Journal of Applied Physics, 2019, vol. 58, SC1047 abstract, pp. 2-6, fig. 5 (b) | 11, 13-15 |
| A | | 1-10, 12 |

Form PCT/ISA/210 (second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022026202 A

- JP 2022026203 A

**Non-patent literature cited in the description**

- **M IWINSKA et al.** Iron and manganese as dopants used in the crystallization of highly resistive HVPE-GaN on native seeds. *Japanese Journal of Applied Physics*, 2019, vol. 58, SC1047